(19)

Europäisches
Patentamt

European
Patent Office

Office européen
des brevets

(11) **EP 3 032 269 B1**

(12) **EUROPEAN PATENT SPECIFICATION**

(45) Date of publication and mention
of the grant of the patent:
**14.12.2016 Bulletin 2016/50**

(51) Int Cl.:
**G01R 21/00** *(2006.01)*    **G01R 19/00** *(2006.01)*

(21) Application number: **15380030.5**

(22) Date of filing: **17.07.2015**

(54) **SYSTEM AND METHOD FOR IDENTIFYING CONNECTIVITY CONDITIONS IN ELECTRICAL NETWORKS**

SYSTEM UND VERFAHREN ZUR IDENTIFIZIERUNG VON ELEKTRISCHEN
NETZWERKVERBINDUNGEN

SYSTEM ET PROCÉDÉ D' IDENTIFICATION DE CONNEXIONS DANS DES RÉSEAUX
ÉLECTRIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.12.2014 US 201414569704**

(43) Date of publication of application:
**15.06.2016 Bulletin 2016/24**

(73) Proprietor: **Ariadna Instruments, S.L.
48340 Amorebieta (ES)**

(72) Inventors:
• **Zuluaga Libano, Iratxe
48940 Leioa (Bizkaia) (ES)**

• **Gil López, Sergio
48410 Orozko (Bizkaia) (ES)**

(74) Representative: **Juncosa Miro, Jaime et al
Torner, Juncosa i Associates, S.L.
Gran Via de les Corts
Catalanes, 669 bis, 1o, 2a
08013 Barcelona (ES)**

(56) References cited:
**EP-A2- 0 673 101        WO-A2-2012/139655
US-A1- 2010 134 089     US-A1- 2014 236 506
US-A1- 2014 368 189     US-A1- 2015 097 699**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Field of the Art

The present invention generally relates to the field of systems for detecting loads connected to a low- and medium-voltage electric distribution network. The present invention particularly relates to a system and method for identifying connectivity conditions in electrical networks.

Definitions of concepts used in this description:

-   Connection point: any connection to a line of the electrical network in which one or more (low-voltage) user loads or one or more (medium-voltage) transformers is connected.
-   Change in current magnitude: a variation of the effective value of electric current or a variation of the instantaneous value of electric current having a duration greater than 1 ms.
-   Effective value: in the measurement thereof, a time window for calculating the effective value which can take up one or more network cycles (50 Hz or 60 Hz) is created, and an event is characterized by a change in the effective value, with an adjustable minimum change threshold (sensitivity) and a positive or negative sign depending on if it is an increase or a decrease in the value thereof.
-   Instantaneous values, for example, current peaks. An event is defined as a change in electric current with a width greater than 1 ms, and less than the period of the alternating electric current wave. This minimum width is analyzed in order to exclude changes susceptible to being spread through other conductors that do not supply energy to the point the connectivity of which is being investigated. The identifying instantaneous values are surge value, width, sign and chronological time, if present.

Background of the invention

International patent application WO 2013/186404 belonging to the present inventor proposes a method and device for identifying connectivities in electrical networks, where the device comprises:

-   first event detection means which can be coupled to a load connection point of the electrical network, which can detect an event comprising a change in the magnitude of the electric current circulating in said connection point,
-   second event detection means which can be coupled to a line of the electrical network, which can detect an event comprising a change in the magnitude of the electric current circulating in said line, and
-   connectivity checking means comparing the events detected by the first event detection means and the events detected by the second event detection means to determine to which line the event produced in the connection point corresponds.

The method of WO 2013/186404 comprises:

-   detecting an event comprising a change in the magnitude of the electric current circulating at a connection point of the electrical network
-   detecting an event comprising a change in the magnitude of the electric current circulating in an electric line, and
-   comparing the changes in magnitude of the electric current detected in the connection point of the network with the changes in magnitude of the electric current detected at the head end of the electric line to determine to which line the event produced in the connection point corresponds.

By means of the invention proposed in WO 2013/186404, when an event is detected at a connection point, the same event must be detected/identified in one of the electric lines, generally at the head end of the electric line, determining that said electric line is the line feeding the mentioned connection point. Although such determination is possible in various situations, there are other situations for which such determination can be erroneous or even impossible to carry out.

This is the case of the following situations which could be described as complex situations due to the difficulty involved in identifying connectivities in such situations:

-   when the electrical network supplies electricity to a large amount of loads, since the values of the changes in magnitude of the currents circulating through a large amount of connection points of the same electric line added to one another will be detected in the electric line, such that it is very difficult, if not impossible, to individually distinguish to which connection points a change detected in the electric line corresponds; particularly when coupling of a load takes place in several lines, and more specifically when said coupling takes place between phases of lines or line, i.e., considering that said connectivity conditions are produced per phase of line/lines;
-   when a client of the electric distribution network is supplied by more than one supply line at the same time, so the current consumed at the head end is approximately divided between the number of lines to which the client is actually connected.
-   when, in networks where cogeneration exists, the current demanded by a given client can come in a mixed form from the power company transformer and the cogeneration source, at an undetermined proportion.

The object of the present invention is to allow identifying connectivities in electrical networks even in the complex situations indicated above by means of identifying, in an unambiguous manner, to which connection point events detected in the electric line correspond.

Brief Description of the Invention

Present invention in a first aspect provides a system for identifying connectivity conditions in electrical networks which, like the devices known in the state of the art, particularly disclosed in WO 2013/186404, comprises:

first event detection means which are coupled to a load connection point of the electrical network, which can detect a change in the magnitude of the electric current circulating at said load connection point; second event detection means which can be coupled to a line of the electric distribution network, which can detect a change in the magnitude of the electric current circulating in said distribution line; and connectivity checking means comparing the events detected by the first event detection means and the events detected by the second event detection means to determine to which distribution line the event produced in the load connection point corresponds, wherein said second event detection means contain a chronological record of one or more first event detection means, as many as there are first event detection means of load connection connected downstream of said distribution line.

Unlike said known technical rule, in the proposed system:

the first event detection means comprise at least one current sensor and at least one clock, and are configured and arranged for detecting at least two events defined as changes in the magnitude of a passive electric current circulating through the load connection point, and the time between said at least two detected events, the second event detection means comprise at least one current sensor and at least one clock, and are configured and arranged for detecting at least two events defined as changes in the magnitude of a passive electric current circulating through at least said distribution line and/or through at least one supply point connected to said at least one distribution line, for supplying electricity thereto, and the time between said at least two detected events, and the connectivity checking means have access to data relating to said times between events, provided by the first and second event detection means, and are configured, arranged and adapted for processing said data by comparing the time between the events detected by the first detection means with the time between the events detected by the second detection means, to determine, based at least on the similarity between said compared times, to which distribution line or lines the load connection point is connected.

The term "passive electric current" refers to an electric current that has not been injected or made to circulate in the electrical network for the purpose of identifying connectivities, and such term has been used to clearly distinguish the present invention from systems based on the injection and subsequent detection of active current signals, and also from any system actively forcing the consumption of a load to follow a specific pattern. In contrast, a passive electric current is a current associated with unforced energy consumption by a load.

For one embodiment:

the first event detection means are configured and arranged for detecting a plurality of said events at said load connection point of an electrical network, and the time pattern followed by said plurality of detected events, the second event detection means are configured and arranged for detecting a plurality of said events in said at least one distribution line, and/or at at least one supply point connected thereto, and the time pattern followed by said plurality of detected events, and the connectivity checking means have access to data relating to said time patterns (for example, in the form of event tables including event time patterns), provided by the first and second event detection means, and are configured, arranged and adapted for processing said data by comparing at least said time patterns (as will be described below, the comparison can be performed also taking into account the detected events) to determine, based on the similarity between said compared time patterns, to which distribution line or lines the load connection point is electrically connected.

According to another preferred embodiment:

the first event detection means are configured and arranged for detecting a plurality of said events at each of a plurality of load connection points of an electrical network, and the time patterns followed by said pluralities of detected events, the second event detection means are configured and arranged for detecting a plurality of said events in each of two or more distribution lines of the electrical network and/or of two or more supply points connected thereto, and the time patterns followed by said pluralities of detected events, and the connectivity checking means have access to data relating to said time patterns, provided by the first and second event detection means, and are configured, arranged and adapted for processing said data by comparing at least said time patterns to determine, based on the similarity between said compared time patterns, to which distribution line or lines each of said load connection points is electrically connected.

For one embodiment, the first and second event detection means are adapted for sending the mentioned data relating to times between events or time patterns to the connectivity checking means through wired or wireless communication links, using any type of suitable technology, such as: PLC, radio, telephony, ADSL, fiber optics, etc. Alternatively, the mentioned data can be gathered *in situ* by an operator and delivered to the connectivity checking means, which can be implemented in a portable computing device, such as a smartphone, a tablet or a laptop, of the actual operator, or implemented by a remote computer.

The connectivity checking detection means can also identify which load connection point or points are susceptible to contributing to non-technical losses in the distribution line or lines (i.e., changes in the power network due to possible fraudulent changes) and generating a warning signal if said contribution of non-technical losses occurs.

The comparison carried out by the connectivity checking means, and even the mentioned identification of the presence of non-technical losses, can be done with an automatic element in the electrical network, i.e., an element with processing and communication capacity, in order to receive the event tables mentioned above and process the data included therein (using a computer program or application that can be run by such element) for generating a connectivity report or database and a warning system in the presence of non-technical losses including the analyzed connectivity data and the warnings generated by means of said data processing, and then sending the connectivity report or database and the corresponding warnings to a remote location, such as the headquarters of the power company supplying electricity through the mentioned distribution lines, or, alternatively, the mentioned comparison can be made in said headquarters, also automatically by means of a computer or the like.

In other words, according to one embodiment of the present invention connectivities are only determined by means of comparing the event time patterns of the loads with those of the distribution line or supply point. Therefore, the magnitudes of the events the time patterns of which are compared do not have to be identical or similar to one another, but their event time sequences must indeed be identical or similar to one another in order to compare them. By means of comparing time patterns, a more reliable identification of connectivities is performed, in comparison with the prior art proposals, particularly when a large amount of loads are connected to the same distribution network which supplies electricity thereto. Alternatively, connectivities could also be determined by means of comparing the time patterns and the detected events.

For one embodiment, the system is applied to an electric distribution network comprising coupled and/or ringed lines, where at least one of said load connection points is connected to two or more of said coupled and/or ringed lines, and where the second event detection means are configured and arranged for detecting said plurality of events and time patterns between events in said two or more coupled and/or ringed lines.

For example, in a ringed network a client can connect an electric load of, for example, 10 A, to a load connection point which can be connected to first and second distribution lines, such that it receives, for example, 8 A from one line and 2 A from the other line. Therefore, all variations of electric consumption at that load connection point will maintain such 8/2 ratio.

According to another embodiment, the second event detection means are configured and arranged for detecting said plurality of events at at least one supply point connected at the head end of the distribution line and at at least another supply point connected to an intermediate point of the same distribution line (such as a point at which the output of a generator or a transformer is connected).

According to one embodiment, the first event detection means comprise, per connection point, an electric consumption meter installed in the connection point (this meter can be the actual meter of the client already installed in the connection point) or a load measuring apparatus coupleable to a transformer of the connection point.

The second event detection means comprise, for one embodiment, an electric current measuring apparatus comprising a toroidal coil (such as a Rogowsky coil) or a current transformer.

Any known current detection mechanism and equivalents can be comprised and used by the first and second event detection means, operating with contact (resistive sensors, etc.) or without contact (current detection by inductive coupling, magnetism, etc.), the present invention not being limited to any specific kind of current detection mechanism.

For one embodiment, the first and second event detection means comprise, at each point at which they detect events and time patterns, storage means for storing in a memory (such as an internal memory) the detected events together with corresponding time stamps indicative of the moments in which the events have occurred, said storage means being connected to an electronic circuit which includes a microprocessor or equivalent (such as a logic circuit) included in the first and second event detection means, and which is also connected with the current detection mechanism used for acquiring the detected current values, detecting the changes in magnitude between same (for example, by means of an algorithm run by the microprocessor or by means of an electric/electronic circuit including at least one comparator) and storing them in a memory.

The clock of the first event detection means is generally independent of the clock of the second event detection means (i.e., they are not synchronized with one another) to perform their respective detections of time or times between events independently.

The system of the invention is valid both for medium-voltage electrical networks (MV), where the mentioned load connection point is generally a distribution transformer, and for low-voltage networks (LV), where the load connection point is an electric service entrance point for a user/client.

Ultimately, in the present invention the term "load connection point" refers to any point of connection to a line of the electrical network which is connected to one or more loads of a user/client (LV) or to one or more transformers (MV).

Present invention in a second aspect also provides a method for identifying connectivity conditions in electrical networks. Unlike the methods known in the state of the art, and particularly the method of WO 2013/186404, the method comprises, in a characteristic manner:

detecting, by a first event detection means which are coupled to a load connection point of the electrical network, at least two events defined as changes in the magnitude of a passive electric current circulating through said load connection point, and the time between said at least two detected events,

detecting, by a second event detection means which can be coupled to a line of the electric distribution network, at least two events defined as changes in the magnitude of a passive electric current circulating through at least said distribution line of the electrical network and/or through at least one supply point connected to said at least one distribution line, for supplying electricity thereto, and the time between said at least two detected events, and

comparing, using a connectivity checking means, the time between the events detected at said load connection point with the time between the events detected in said at least one distribution line of the electrical network, and/or at said at least one supply point, to determine, based at least on the similarity between said compared times, to which distribution line or lines the load connection point is connected.

According to one embodiment, the method comprises storing in a memory the detected events together with corresponding time stamps indicative of the moments in which the events have occurred.

According to one embodiment, the method further comprises applying a mathematical or statistical function for identifying if the load connection point contributes to non-technical losses in the distribution line or lines. This mathematical or statistical function links the physical magnitudes, measured by said second event detection means, with those of the first event detection means, said physical magnitudes comprising at least the instantaneous intensity, RMS or energy.

In one embodiment, the mathematical or statistical function comprises the use of at least two independent variables including a change in amplitude of the detected events and the time difference thereof.

For one embodiment, the method comprises running code instructions of a computer program using at least one processor to process data relating to the times between events and perform the mentioned comparison thereof and determination of to which distribution line or lines the load connection point is connected. Such computer program is also included in the present invention, in a manner independent of the rest of the aspects thereof, i.e., of the method and system proposed by the invention.

Brief Description of the Drawings

The foregoing and other advantages and features will be more clearly understood based on the following detailed description of an embodiment in reference to the attached drawings which must be interpreted in an illustrative and non-limiting manner, in which:

Figure 1 schematically shows the device of the present invention with the first and second event detection means connected to a low-voltage network (LV), the reference numbers of Figure 1 of patent WO 2013/186404 having been maintained.

Figure 2 schematically shows the device of the present invention with the first and second event detection means connected to a medium-voltage network (MV), the reference numbers of Figure 2 of patent WO 2013/186404 having been maintained.

Figure 3 shows an event time pattern recorded at a supply source, i.e., at the head end of the distribution network.

Figure 4 shows an event time pattern recorded at a load connection point, particularly in an electric consumption meter of a client connected to the electric distribution network.

Figure 5 is a graph showing, in combination, events detected at the supply source and events detected in the meter of the client, sharing one and the same time pattern between events.

Figure 6 is a graph showing the invariability between the time patterns of events detected in the meter of the client ("meter events") with respect to the time patterns of events detected at the supply source ("source events").

Figure 7 graphically shows the results of the function and (which will be described below) for different dt values, where said function is iteratively run by an algorithm of the present invention.

<u>Detailed Description of several Embodiments</u>

The present invention allows detecting and recording in a memory the time patterns between events occurring at at least two points of an electrical network, for the purpose of determining the connectivity between them, and even identifying the presence of non-technical losses, for which at least two event detection means must be installed, one "upstream" of the electric distribution network, connected at the head end of the distribution line, and the other "downstream" in the network, connected to a connection point.

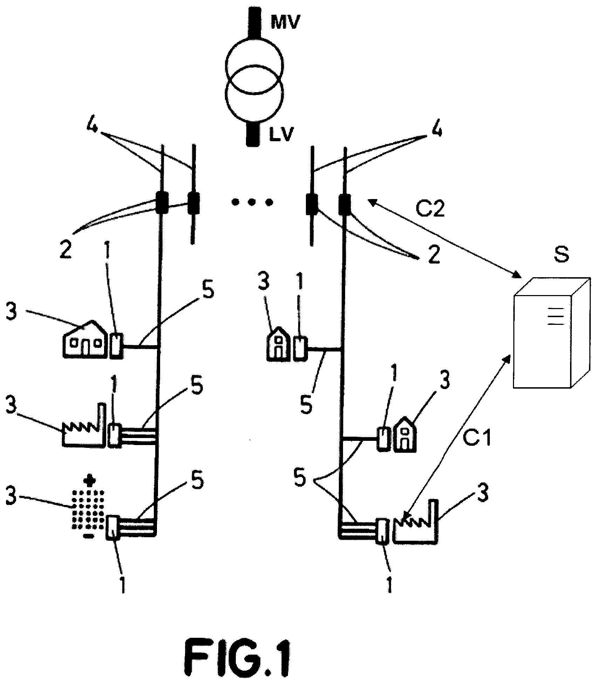

Figure 1 schematically illustrates a low-voltage distribution network (LV) comprising a series of electric distribution lines (4) at the load connection points (5) of which a series of loads (3) are connected.

According to the present invention, first event detection means (1) are coupled at each load point (5) for detecting and recording time patterns between the events generated by loads connected "downstream" of the point of installation thereof and/or the events themselves. For a preferred embodiment, the first event detection means (1) installed at the load connection points (5) record the time patterns between events generated by the loads (3) connected to the corresponding load point and, optionally, the events themselves. The first event detection means (1) preferably comprise or are implemented by the electric current measurement meters installed at each load point which currently allow measuring the power consumption of each client or user.

As also seen in Figure 1, second event detection means (2) are coupled to each electric distribution line (4), where said second event detection means (2) allow detecting the events occurring in each line (4), particularly the events generated downstream of the point of installation thereof and the time pattern between the events. The second event detection means (2) therefore detect a change in the magnitude of the electric current flowing through said electric distribution lines (4) and the time pattern of several detected events.

The second event detection means (2) thus allow detecting the loads connected to that point including the events, if any, detected by all the first event detection means (1) connected downstream of the electric distribution line (4) thereof.

The event detection means (1, 2) preferably include storage means for storing the detected events and the time patterns between them, for example, in an internal memory of the event detection means (1, 2).

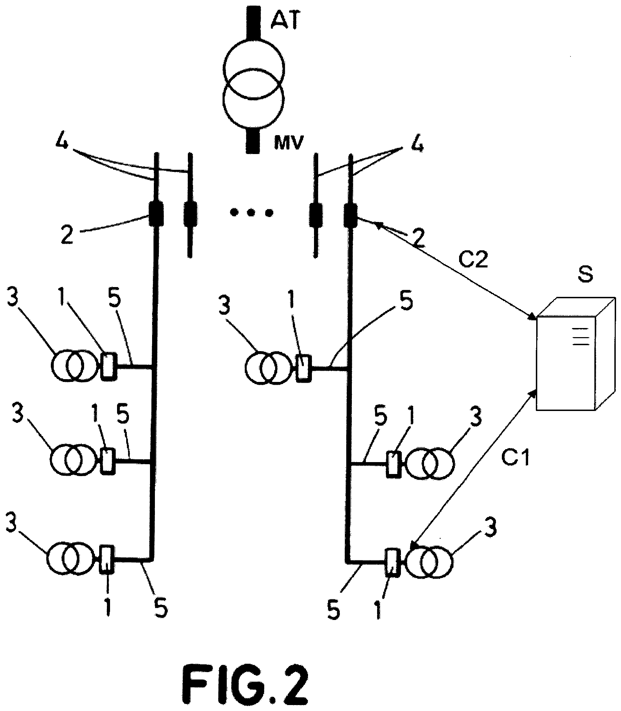

Figure 2 shows a schematic depiction of a medium-voltage distribution network (MV) consisting of a series of electric distribution lines (4) with load connection points (5) in which transformers (3) are connected.

As in the case a low-voltage network (LV), the second event detection means (2) are coupled to each line (4). The first event detection means (1) are also coupled to each load connection point (5) for detecting changes in the magnitude of the current flowing, in this case, through each transformer (3) and the time patterns between the detected changes, and for recording said time patterns and, optionally, the actual changes in the magnitude of the current.

To determine the connectivity between two points of the network, and alternatively also to identify the presence of non-technical losses in each electric distribution line (4), the time patterns recorded by the second event detection means (2) at the head end of the distribution line (4) must be cross-checked with the time patterns detected by the first event detection means (1) at the load connection points (5), i.e., a time pattern cross-checking is performed. An algorithm for performing such time pattern cross-checking will be described below.

For one embodiment, a detected event cross-checking is also carried out complementary to said time pattern cross-checking.

Those event time patterns corresponding to a specific load connection point (5) will only be present in the second event detection means (2) recording time patterns at the head end of the distribution line (4) distributing electricity to that specific load connection point (5), and never at other head ends of other distribution lines (4), adjacent conductors, wires, etc.

The second event detection means (2) of the head end of the distribution line (4) contain a chronological record of one or more of the first event detection means (1) of the load connection points (5), as many as there are first event detection means (1) of load connection points (5) connected downstream of said distribution line (4).

Both Figure 1 and Figure 2 depict the connectivity checking means implemented by a computer (S), in this case, for the sake of clarity, connected only to one of the first event detection means (1) (through connection link C1) and to one of the second event detection means (2) (through connection link C2). For a preferred embodiment, the connectivity checking means (S) are connected to all the first and all the second event detection means (1, 2). The connectivity checking means (S) are connected with the event detection means (1, 2) for gathering data recorded therein, including at least the event time patterns.

Information about events and time patterns between events can be sent through communication links (C1 and C2 in Figures 1 and 2) by implementing any of the following technologies: PLC, radio, telephony, ADSL, fiber optics, etc., and can even be gathered *in situ* by an operator.

After that, event tables including event time patterns provided by the first event detection means (1) of the clients at the load connection points (5) are compared with event tables including event time patterns provided by the second event detection means (2) of the head end of the distribution line (4) to determine the connectivity data of the electrical network and alternatively to also generate a warning signal in the presence of non-technical losses in each distribution lines (4).

Examples of asynchronous event time pattern detection in electrical networks:

To compare current events between two event detection means recording the current measurements at the head end of the network and at the connection point of a client, according to a first embodiment, it is preferable to only use the time information of the events rather than the magnitude of the events. Nevertheless, the proposed method can also be used for comparing events and determining similarity or dissimilarity, by means of a mathematical or statistical function (explained in detail below) involving the use of at least two independent variables (change in the amplitude of the events and time difference thereof), and not the use of each of said variables separately.

Nonetheless, each of the event detection means of the present invention further adds a time stamp to an event which must not necessarily coincide with the time stamp added by another one of the event detection means detecting and recording the same event, since the clocks of each one will always have a time error between them.

This value is usually unknown, and can be of several seconds, minutes and even hours in actual systems.

Therefore, the following definitions can be established:

- Current event: number (or sequence of numbers) determining a change in the magnitude of the electric current greater than a predetermined threshold.
- Time stamp: stamp indicating the instant in which the event detection means detect an event, time referring said event to its internal clock. This clock indicates a relative hour, since it will always have a time shift with respect to an absolute time.

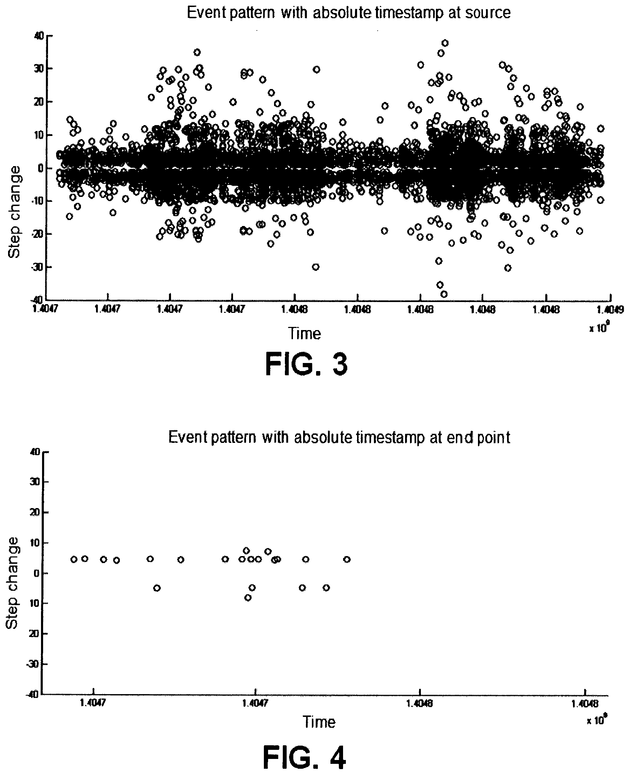

Figures 3 and 4 show by means of two respective graphs one embodiment of the present invention in relation to two event time patterns: one detected at the head end of the distribution network (source) and another detected in the client consumption meter (connection point).

Variability of load amplitude:

The magnitude of the events measured at the connection point of the client does not have to coincide with the magnitude of the events detected at the head end of the network, due to the manner in which the loads are connected in three-phase distribution systems.

In an electric distribution network, the current measured at the head end of the network is the result of connecting multiples loads simultaneously, taking into account the manner of connecting each load and the power factor of each of them. According to the type of distribution of the network, the loads can be single-phase, two-phase or three-phase.

Therefore, for a given current event the client meter (implementing the first event detection means) will detect same as a variation of current which in amplitude will depend on the sum of the current vector with the connected loads of that client.

In contrast, the measurement system located at the head end (i.e., the second event detection means) will detect same added to rest of the loads of the entire network it monitors.

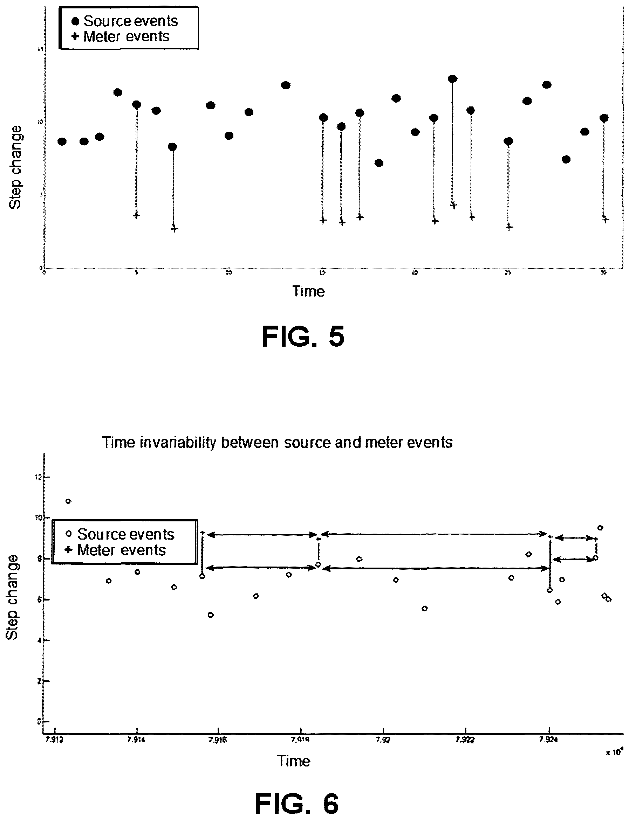

All this causes the magnitude of the increase (or decrease) of the current detected by a client meter to be translated at the head end to a value which can be less (greater) in amplitude, depending on the described previously circumstances present in the appearance of each event (lack of synchronism, single-/two- or three-phase characteristics of the loads, time coincidence in the appearance of events of different client meters, etc.). Figure 5 shows a special case where, systematically, the "meter events", referring to events detected by the client consumption meter and the "source events", referring to the same events but detected at the head end, show a quantitatively and systematically significant decrease, of the former with respect to the latter generating a warning indicative of the presence of non-technical losses

This means that the amplitudes of the detected events have such variability in their magnitude making comparison between the head end and client meter difficult.

Furthermore, a client in the electric distribution networks can be supplied by more than one supply line at the same time, so the current consumed at the head end is approximately divided between the number of lines to which the client is actually connected.

On top of that, in networks where cogeneration exists, the current demanded by a given client can come in a mixed form from the power company transformer and the cogeneration source, at an undetermined proportion.

Invariability of time between events:

Each event is characterized by its magnitude of change and a time stamp added by the event detection means recording it.

An example of the variations between the amplitudes of the events when they are detected in the client meter, i.e., the "meter events", in comparison with the same events when they are detected at the head end, i.e., the "source events", and of the invariability between the time patterns of the "meter events" with respect to the time patterns of the "source events".

As has been explained above, the same event can be detected in several locations along the electric line with various event detection means having clocks not necessarily synchronized with one another. They can record the same event but each one assigns its time stamp referring to its internal clock.

Therefore, one and the same event will be recorded in the two event detection means with two different time values, in which the time difference of the clocks of the two event detection means is included.

When a series of events are recorded, the same will occur, i.e., each system will reference the detected events by adding thereto the time shift its internal clock has with respect to the time reference of the head end.

The two event detection means will record respective event patterns very similar to one another if the time stamps are taken as relative times rather than at absolute times.

The system, particularly the connectivity checking means, which must determine the similarity of both event time pattern records must take into account the times between events measured by each event detection means, and not the absolute times of the events, since these will contain absolute errors which in actual applications can range from seconds to several minutes, and in some cases even hours.

The best way to counteract the time shift of the clocks is to use the relative times between events of each pattern, since the error of these measurements will be minimum in a time period of one or more days. The latter will only depend on the drift of each clock with itself (for example, for household meters generally less than 1 s/day).

If over the graph showing the event time pattern at the head end (for example, the graph of Figure 3) there is overlapped the graph showing the event time pattern of the meter (for example, the graph of Figure 4), then the latter can slid over the former along the x-axis, and at a point, a significant number of points of both graphs will coincide when the suitable time shift is achieved. This shift, unknown a priori, will coincide with the time difference of the clocks of the two event detection means.

The algorithm running the mentioned mathematical or statistical function used by the present invention for one embodiment will be described below.

Said algorithm is implemented by means of the code instructions of the computer program described in a preceding section.

Description of the algorithm:

Each event i detected by the event detection means of the load connection point, i.e., of the first event detection means, is characterized by its time stamp *mts* and its event amplitude *ma,* according to the expression:

$$mev_i = \{mts_i, ma_i\}$$

A sequence of events *rmev* rev produces a time pattern generated by the loads connected to the measurement meter with *n* events according to the expression:

$$rmev = \{ mev_1, mev_2, \ldots, mev_n \}$$

Similarly, the event detection means of the head end, i.e., the second event detection means, records event amplitudes *ha* with their time stamp *hts* according to the expression:

$$hev_i = \{hts_i, ha_i\}$$

where a sequence of events *rhev* produces an event time pattern with n events according to the expression:

$$rhev = \{ hev_1, hev_2, \ldots, hev_n \}$$

To compare both patterns, an arbitrary time shift *dt* is first added to one of the two mentioned sequences of events, for example a *rmev*:

$$mev_{i,dt} = \{mts_i + dt, ma_i)$$

$$rmev_{dt} = \{ mev_{1,dt}, mev_{2,dt}, \ldots, mev_{n,dt} \}$$

A function is then applied for comparing both sequences:

$$y_{dt} = f(rmev_{dt}, rhev)$$

The function $y_{dt}$, simplified as function *y=f*(x1, x2) has the following characteristic:

$$y \rightarrow +1 \qquad \text{if } x1 \in x2$$

$$y \rightarrow -1 \qquad \text{if } x1 \notin x2$$

In the preceding function y, amplitude information ($ha_i$ and $ma_i$) has been normalized for comparing the mentioned event time patterns, although for another embodiment which also includes comparing the amplitude values, said amplitude information is not normalized since it is taken into account for the comparison.

The algorithm preferably runs the function y by means of iteratively varying the *dt* values and, for each dt value, checking if the function gives a result equal or close to +1. When a relative time error is found between both event time patterns, i.e., when said result equal or close to +1 is achieved, a positive detection is obtained.

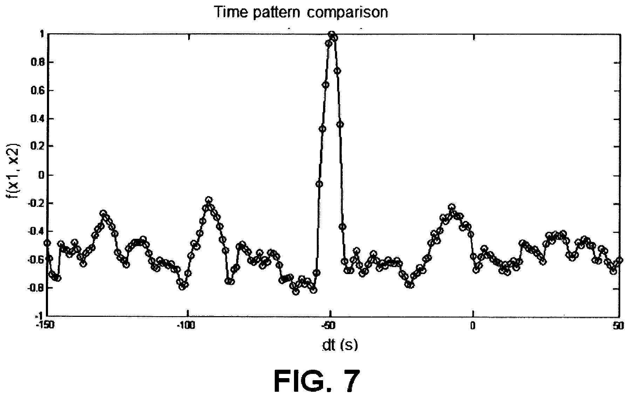

Figure 7 graphically shows the result of the function *y* for different *dt* values, where a positive detection has been obtained for dt = 50 s.

The statistical or mathematical function described above is provided for counteracting the magnitude and time information simultaneously, working with all the events obtained from the first event detection means (for example, an electric meter) and second event detection means (for example, an electric current measuring apparatus at the level of head end) between established dates or, applying cross-validation schemes in which the events obtained between the specified dates are not treated together, but rather divided into blocks (using criteria based on information content, or any other criteria) of events in which, and working in an independent manner, the mentioned statistical or mathematical function applies/makes decisions about each block and the final decision making process is established by means of majority voting schemes, or any other, for increasing detection process efficiency and reducing false associations.

The invention also additionally contemplates the implementation thereof by means of using devices and methods for estimating the position of the electric meters (end users) along the low-voltage distribution line, taking the measurements of the head end of the line as a reference (starting point of that sequencing).

According to these additional measurements, there must be provided, in addition to the events in electric meters and in the electric current measuring apparatus, voltage measurements, current measurements and Pi cosines (angle between voltage and strength). To it must be taken into account that electric distribution must assure approximately constant voltage values along all distribution lines for the sake of being able to assure suitable supply quality in the power contracted by network users.

The ratio between voltages and strengths defines line impedances (a measurement of the resistance shown by the distribution means, particularly wires, to the passage of current). The value of said impedances is determined by the characteristics of the physical media through which the current is distributed and, can normally be estimated using inventory data of the power companies which relates to wire section, number of service years, construction material, distance, etc. Taking into account that current (consumption) variation involves variations in network voltages, variations which, on the other hand, affect the rest of the users associated with the same distribution line, the sequence/order of the electric meters along the distribution line can be established by knowing the time instants in which passage of current occurs in each of the electric meters (through event information).

Likewise, the invention also establishes the possibility of obtaining a greater number of load events throughout the day. In this case, use of resources associated with capturing or measuring the events of the different electric meters is optimized by means of considering two fundamental points: 1) limiting the maximum number of possible daily events that can be obtained, and 2) assuring at all times the presence of the most significant events. For the sake of comparing both points, once the memory of the physical media used in capturing the mentioned events is full, if an amplitude event greater than any of those already obtained events occurs, said event is included in the memory eliminating from same the less significant event stored up to that moment.

Particularly, by means of using a sufficient number of events relating to each of the electric meters connected to the same phase of line, the signal of the head end (electric current measuring apparatus) can be reconstructed using rule-based inference methods, interpolating the knowledge provided by the individual events of each meter electric. To that end, said methods are applied on the set of events measured for each of the electric meters in the considered time period, which time period is preferably fixed and common for the group of electric meters associated by connectivity with the phase of line to be reconstructed. Once the event time signals for each of the meters in the specified time period are reconstructed, the individual signals of the different electric meters are added, thereby reconstructing the global signal at the head end.

By comparing said reconstruction with the actual signal (events) of each phase of each electric current measuring apparatus at the head end, forms or structures (loads) on the measured time series of the head end which cannot be associated with the signal reconstructed from the addition of the individual series of the electric meters are identified. If the connectivity is high or at least the (remotely controlled) monitored power is high, for example, in the order of 99-100%, the unidentified loads can be associated with illegal direct connections to the network (fraud). With said identified current values on the loads not associated with power invoiced by the distribution company, fluctuations that must occur on the voltages along the distribution line can be identified. Losses (non-technical) associated with said illegal connections on the distribution line itself can be sequenced with said information.

Similarly, once the invention has established the connectivity of a specific electric meter (end user) on an electric current measuring apparatus (involves having the signals of both synchronous parts) it can apply a new statistical or mathematical function for detecting a type of non-technical losses (fraud) associated with partial manipulation of electric meters (Figure 5). In this case, the new statistical or mathematical function involves the statistical study of the ratios established between all the synchronous coincidences (events) between the electric meter and the electric current measuring apparatus at the head end, identifying those cases that do not have a biunivocal systemic counterpart (1:1) at the level of electric meter. Said statistical or mathematical function must ratify the systematization of the quantitative differences. In said case, electric meter losses to electric current measuring apparatus at the head end are reduced and a warning system is established for identifying that electric meter as being suspicious. In this last case, the new mathematical or statistical function links the physical magnitudes, measured at the level of electric current measuring apparatus at the head end, with those of the electric meters (instantaneous strength, RMS or power) such that if what is systematically measured in the electric current measuring apparatus at the head end, preventing time coincidences between events of different electric meters and taking into account the coupling considerations (between phases or lines) already mentioned, does not comply with power conservation principles, or Kirchhoff's laws, said electric meter is indicated as being suspicious of generating non-technical losses.

In the present memory, the word "comprises" and its variants such as "comprising", etc. must not be interpreted in an exclusive manner, i.e., the use of those terms does not exclude the possibility of the invention as described above being able to include other elements, steps, etc.

Furthermore, the invention is not limited to the specific embodiments described, but rather also covers, for example, variants thereof which can be carried out by a person skilled in the art, for example, with respect to the selection of materials, dimensions, components, configurations, etc., without departing from the scope of the invention as defined in the attached claims.

## Claims

1. A system for identifying connectivity conditions in electrical networks, comprising:

   first event detection means (1) which are coupled to a load connection point (5) of the electrical network, which can detect a change in the magnitude of the electric current circulating at said load connection point (5);
   second event detection means (2) which can be coupled to a line (4) of the electric distribution network, which can detect a change in the magnitude of the electric current circulating in said distribution line (4); and
   connectivity checking means comparing the events detected by the first event detection means (1) and the events detected by the second event detection means (2) for determining to which line the event produced in the load connection point (5) corresponds,

   wherein said second event detection means (2) contain a chronological record of one or more first event detection means (1), as many as there are first event detection means (1) of load connection (5) connected downstream of said distribution line (4),
said system being **characterized in that**:

   the first event detection means (1) comprise at least one current sensor and at least one clock, and are configured and arranged for detecting at least two events defined as changes in the magnitude of a passive electric current circulating through said load connection point (5), and the time between said at least two detected events,
   the second event detection means (2) comprise at least one current sensor and at least one clock, and are configured and arranged for detecting at least two events defined as changes in the magnitude of a passive electric current circulating through at least said distribution line (4) and/or through at least one supply point connected to said at least one distribution line (4), for supplying electricity thereto, and the time between said at least two detected events, and
   the connectivity checking means have access to data relating to said times between events, provided by the first and second event detection means (1, 2), and are configured, arranged and adapted for processing said data by comparing the time between the events detected by the first detection means (1) with the time between the events detected by the second detection means (2), to determine, based at least on the similarity between said compared times, to which distribution line or lines the load connection point (5) is connected.

2. The system according to claim 1, wherein:

   the first event detection means (1) are configured and arranged for detecting a plurality of said events at said load connection point (5) of an electrical network, and the time pattern followed by said plurality of detected events,
   the second event detection means (2) are configured and arranged for detecting a plurality of said events in said at least one distribution line (4), and/or at at least one supply point connected thereto, and the time pattern followed by said plurality of detected events, and
   the connectivity checking means have access to data relating to said time patterns, provided by the first and second event detection means (1, 2), and are configured, arranged and adapted for processing said data by comparing said time patterns to determine, based at least on the similarity between said compared time patterns, to which distribution line or lines (4) the load connection point (5) is electrically connected.

3. The system according to claim 2, wherein:

the first event detection means (1) are configured and arranged for detecting a plurality of said events at each of a plurality of load connection points (5) of an electrical network, and the time patterns followed by said pluralities of detected events,

the second event detection means (2) are configured and arranged for detecting a plurality of said events in each of two or more distribution lines (4) of the electrical network and/or of two or more supply points connected thereto, and the time patterns followed by said pluralities of detected events, and

the connectivity checking means have access to data relating to said time patterns, provided by the first and second event detection means (1, 2), and are configured, arranged and adapted for processing said data by comparing said time patterns to determine, based on the similarity between said compared time patterns, to which distribution line or lines (4) each of said load connection points (5) is electrically connected.

4. The system according to any one of the preceding claims, wherein the connectivity checking detection means are further configured for identifying which load connection point or points (5) are susceptible to contributing to non-technical losses in the distribution line or lines (4) and generating a warning signal if said contribution of non-technical losses occurs.

5. The system according to claim 3, wherein the system is applied to an electric distribution network comprising coupled and/or ringed lines, where at least one of said load connection points (5) is connected to two or more of said coupled and/or ringed lines, and where the second event detection means (2) are configured and arranged for detecting said plurality of events and time patterns between events in said two or more coupled and/or ringed lines.

6. The system according to claim 3, wherein the second event detection means are configured and arranged for detecting said plurality of events at at least one supply point connected at the head end of the distribution line (4) and at at least another supply point connected to an intermediate point of the same distribution line (4).

7. The system according to claim 1, wherein the at least one clock of the first event detection means (1) is independent of the at least one clock of the second event detection means (2) to perform their respective detections of time or times between events independently.

8. The system according to claim 1, wherein the first event detection means (1) and the second event detection means (2) comprise storage means for storing in a memory the detected events together with corresponding time stamps indicative of the moments in which the events have occurred.

9. A method for identifying connectivity conditions in electrical networks, comprising:

detecting, by a first event detection means which are coupled to a load connection point of the electrical network, an event comprising a change in the magnitude of the electric current circulating in said connection point of the electrical network,

detecting, by a second event detection means which are coupled to a line of the electric distribution network, an event comprising a change in the magnitude of the electric current circulating in said line of the electric distribution network, and

comparing, by a connectivity checking means, the changes in magnitude of the electric current detected in the connection point of the network with the changes in magnitude of the electric current detected in the electric line to determine to which line the event produced in the connection point corresponds,

wherein said second event detection means (2) contain a chronological record of one or more first event detection means (1), as many as there are first event detection means (1) of load connection (5) are connected downstream of said distribution line (4), **characterized in that** the method further comprises:

detecting, by the first event detection means, at least two events defined as changes in the magnitude of a passive electric current circulating through said load connection point of an electrical network, and the time between said at least two detected events,

detecting, by the second event detection means, at least two events defined as changes in the magnitude of a passive electric current circulating through at least said distribution line of the electrical network and/or through at least one supply point connected to said at least one distribution line, for supplying electricity thereto, and the time between said at least two detected events, and

comparing, by the connectivity checking means, the time between the events detected at said load connection point with the time between the events detected in said at least one distribution line of the electrical network, and/or at said at least one supply point, to determine, based at least on the similarity between said compared times, to which distribution line or lines the load connection point is connected.

10. The method according to claim 9, further comprising:

detecting, by the first event detection means, a plurality of events at said load connection point of an electrical network and the time pattern followed by said plurality of detected events; detecting, by the second event detection means, a plurality of said events in said at least one distribution line of the electrical network, and/or at at least one supply point connected thereto, and the time pattern followed by said plurality of detected events, and

processing, by the connectivity checking means, said detected data by comparing said time patterns to determine, based at least on the similarity between said compared time patterns, to which distribution line or lines the load connection point is connected.

11. The method according to claim 9 or 10, further comprising performing a time pattern cross-checking and a detected event cross-checking to determine to which distribution line or lines the load connection point is connected.

12. The method according to claim 9, comprising storing in a memory the detected events together with corresponding time stamps indicative of the moments in which the events have occurred.

13. The method according to any one of the preceding claims 9 to 12, further comprising applying a mathematical or statistical function for identifying if the load connection point contributes to non-technical losses in the distribution line or lines, wherein said mathematical or statistical function relates physical magnitudes measured by said second event detection means with physical magnitudes measured by the first event detection means, said physical magnitudes comprising at least the instantaneous intensity, RMS or energy.

14. The method according to claim 13, wherein said mathematical or statistical function comprises the use of at least two independent variables including a change in amplitude of the detected events and the time difference thereof.

15. The method according to claim 9 or 10, comprising running code instructions of a computer program using at least one processor to process data relating to said times between events and perform said comparison thereof and determination of to which distribution line or lines the load connection point is connected.

16. The method according to claim 15, wherein said code instructions perform said comparison further taking into account the similarity of the compared events to determine to which distribution line or lines the load connection point is connected.

**Patentansprüche**

1. System zur Identifizierung von elektrischen Netzwerkverbindungen, umfassend:

erste Ereigniserkennungsmittel (1), welche mit einem Lastanschlusspunkt (5) des elektrischen Netzwerks gekoppelt sind, welche eine Veränderung bei der Größenordnung des an diesem Lastanschlusspunkt (5) fließenden elektrischen Stroms erkennen können; zweite Ereigniserkennungsmittel (2), welche mit einer Leitung (4) des elektrischen Verteilernetzwerkes gekoppelt werden können, welche eine Veränderung bei der Größenordnung des in der genannten Verteilerleitung (4) fließenden elektrischen Stroms erkennen können; und Konnektivitätsprüfmittel, welche die von den ersten Ereigniserkennungsmitteln (1) erkannten Ereignisse und die von den zweiten Ereigniserkennungsmitteln (2) erkannten Ereignisse vergleichen, um zu bestimmen, welcher Leitung entspricht das im Lastanschlusspunkt (5) erzeugte Ereignis, wobei die genannten zweiten Ereigniserkennungsmittel (2) eine chronologische Aufzeichnung des einen oder der mehreren ersten Ereigniserkennungsmittel (1) enthalten, so viele wie erste Ereigniserkennungsmittel (1) zum Lastanschluss (5), welche stromabwärts der genannten Verteilerleitung (4) angeschlossen sind, wobei das System **dadurch gekennzeichnet ist, dass**:

die ersten Ereigniserkennungsmittel (1) mindestens einen Stromsensor und mindestens einen Zeitgeber umfassen, und dazu ausgebildet und angeordnet sind, mindestens zwei als Veränderungen bei der Größenordnung definierte Ereignisse eines durch den genannten Lastanschlusspunkt (5) fließenden passiven elektrischen Stroms, und die Zeit zwischen den genannten mindestens zwei erkannten Ereignissen zu erkennen, die zweiten Ereigniserkennungsmittel (2) mindestens einen Stromsensor und mindestens einen Zeitgeber umfassen, und dazu ausgebildet und angeordnet sind, mindestens zwei als Veränderungen bei der Größenordnung definierte Ereignisse eines passiven elektrischen Stroms, welcher durch mindestens die genannte Verteilerleitung (4) und/oder durch mindestens einen mit mindestens einer Verteilerleitung (4) angeschlossenen Versorgungspunkt, für deren Versorgung mit Elektrizität, fließt, und die Zeit zwischen den genannten mindestens zwei erkannten Ereignissen zu erkennen, und

die Konnektivitätsprüfmittel Zugang zu Daten haben, welche die genannten Zeiten zwischen Ereignissen betreffen, welche von den ersten und zweiten Ereigniserkennungsmitteln (1, 2) bereitgestellt werden, und dazu ausgebildet, angeordnet und angepasst sind, die genannten Daten zu verarbeiten, indem die Zeit zwischen den von den ersten Erkennungsmitteln (1) erkannten Ereignissen mit der Zeit zwischen den von den zweiten Erkennungsmitteln (2) erkannten Ereignissen verglichen werden, um zu bestimmen, basierend mindestens auf der Ähnlichkeit zwischen den genannten verglichenen Zeiten, an welcher Verteilerleitung oder welchen Verteilerleitungen der Lastanschlusspunkt (5) angeschlossen ist.

2. System nach Anspruch 1, wobei:

die ersten Ereigniserkennungsmittel (1) dazu ausgebildet und angeordnet sind, eine Vielzahl von den genannten Ereignissen an dem genannten Lastanschlusspunkt (5) eines elektrischen Netzwerks, und das von der genannten Vielzahl von erkannten Ereignissen gefolgte Zeitraster zu erkennen, die zweiten Ereigniserkennungsmittel (2) dazu ausgebildet und angeordnet sind, eine Vielzahl von den genannten Ereignissen in der genannten mindestens einen Verteilerleitung (4), und/oder an mindestens einem daran angeschlossenen Versorgungspunkt, und das von der genannten Vielzahl von erkannten Ereignissen gefolgte Zeitraster zu erkennen, und die Konnektivitätsprüfmittel Zugang zu Daten haben, welche die genannten Zeitraster betreffen, welche von den ersten und zweiten Ereigniserkennungsmitteln (1, 2) bereitgestellt werden, und dazu ausgebildet, angeordnet und angepasst sind, die genannten Daten zu verarbeiten, indem die genannten Zeitraster verglichen werden, um zu bestimmen, basierend mindestens auf der Ähnlichkeit zwischen den genannten verglichenen Zeitrastern, an welcher Verteilerleitung oder welchen Verteilerleitungen (4) der Lastanschlusspunkt (5) elektrisch angeschlossen ist.

3. System nach Anspruch 2, wobei:

die ersten Ereigniserkennungsmittel (1) dazu ausgebildet und angeordnet sind, eine Vielzahl von den genannten Ereignissen an jedem einer Vielzahl von Lastanschlusspunkten (5) eines elektrischen Netzwerks, und die von der genannten Vielzahl von erkannten Ereignissen gefolgten Zeitraster zu erkennen, die zweiten Ereigniserkennungsmittel (2) dazu ausgebildet und angeordnet sind, eine Vielzahl von den genannten Ereignissen in jeder von zwei oder mehreren Verteilerleitungen (4) des elektrischen Netzwerks und/oder von zwei oder mehreren daran angeschlossenen Versorgungspunkten, und die von der genannten Vielzahl von erkannten Ereignissen gefolgten Zeitraster zu erkennen, und die Konnektivitätsprüfmittel Zugang zu Daten haben, welche die genannten Zeitraster betreffen, welche von den ersten und zweiten Ereigniserkennungsmitteln (1, 2) bereitgestellt werden, und dazu ausgebildet, angeordnet und angepasst sind, die genannten Daten zu verarbeiten, indem die genannten Zeitraster verglichen werden, um zu bestimmen, basierend auf der Ähnlichkeit zwischen den genannten verglichenen Zeitrastern, an welcher Verteilerleitung oder welchen Verteilerleitungen (4) jeder der genannten Lastanschlusspunkte (5) elektrisch angeschlossen ist.

4. System nach einem der vorhergehenden Ansprüche, wobei die Erkennungsmittel, welche die Konnektivität prüfen, zusätzlich dazu ausgebildet sind, welcher Lastanschlusspunkt oder welche Lastanschlusspunkte (5) zu den nicht-technischen Verlusten in der Verteilerleitung oder den Verteilerleitungen (4) beitragen können und ein Warnsignal erzeugen können, wenn dieser Beitrag von nicht-technischen Verlusten stattfindet, zu identifizieren.

5. System nach Anspruch 3, wobei das System in einem elektrischen Verteilernetzwerk angewendet wird, umfassend gekoppelte und/oder verbundene Leitungen, wobei mindestens einer der genannten Lastanschlusspunkte (5) an zwei oder mehreren der genannten gekoppelten und/oder verbundenen Leitungen angeschlossen ist, und wobei die zweiten Ereigniserkennungsmittel (2) dazu ausgebildet und angeordnet sind, die genannte Vielzahl von Ereignissen und Zeitrastern zwischen Ereignissen in den genannten zwei oder mehreren gekoppelten und/oder verbundenen Leitungen zu erkennen.

6. System nach Anspruch 3, wobei die zweiten Ereigniserkennungsmittel dazu ausgebildet und angeordnet sind, die genannte Vielzahl von Ereignissen an mindestens einem Versorgungspunkt, welcher an dem Kopfende der Verteilerleitung (4) angeschlossen ist, und an mindestens einem anderen Versorgungspunkt, welcher an einem Zwischenpunkt der gleichen Verteilerleitung (4) angeschlossen ist, zu erkennen.

7. System nach Anspruch 1, wobei der mindestens eine Zeitgeber der ersten Ereigniserkennungsmittel (1) unabhängig von dem mindestens einen Zeitgeber der zweiten Ereigniserkennungsmittel (2) ist, um ihre jeweilige Erkennung der Zeit oder Zeiten zwischen Ereignissen unabhängig durchzuführen.

8. System nach Anspruch 1, wobei die ersten Ereigniserkennungsmittel (1) und die zweiten Ereigniserkennungsmittel (2) Speichermittel umfassen, um die erkannten Ereignisse zusammen mit entsprechenden Zeitstempeln, welche die Zeitpunkte in welchen die Ereignisse stattgefunden haben bezeichnen, in einem Speicher zu speichern.

9. Verfahren zur Identifizierung von elektrischen Netzwerkverbindungen, umfassend:

    das Erkennen, durch erste Ereigniserkennungsmittel die mit einem Lastanschlusspunkt des elektrischen Netzwerks gekoppelt sind, eines Ereignisses umfassend eine Veränderung bei der Größenordnung des in dem genannten Anschlusspunkt des elektrischen Netzwerkes fließenden elektrischen Stroms,
    das Erkennen, durch zweite Ereigniserkennungsmittel die mit einer Leitung des elektrischen Verteilernetzwerkes gekoppelt sind, eines Ereignisses umfassend eine Veränderung bei der Größenordnung des in der genannten Leitung des elektrischen Verteilernetzwerkes fließenden elektrischen Stroms, und
    das Vergleichen, durch Konnektivitätsprüfmittel, der Veränderungen bei der Größenordnung des im Anschlusspunkt des Netzwerks erkannten elektrischen Stroms mit den Veränderungen bei der Größenordnung des in der elektrischen Leitung erkannten elektrischen Stroms, um zu bestimmen, welcher Leitung entspricht das im Anschlusspunkt erzeugte Ereignis,
    wobei die genannten zweiten Ereigniserkennungsmittel (2) eine chronologische Aufzeichnung des einen oder der mehreren ersten Ereigniserkennungsmittel (1) enthalten, so viele wie erste Ereigniserkennungsmittel (1) zum Lastanschluss (5), welche stromabwärts der genannten Verteilerleitung (4) angeschlossen sind,
    **dadurch gekennzeichnet, dass** das Verfahren zusätzlich Folgendes umfasst:

    das Erkennen, durch die ersten Ereigniserkennungsmittel, mindestens zweier als Veränderungen bei der Größenordnung definierten Ereignisse eines durch den genannten, Lastanschlusspunkt eines elektrischen Netzwerks fließenden passiven elektrischen Stroms, und der Zeit zwischen den genannten mindestens zwei erkannten Ereignissen,
    das Erkennen, durch die zweiten Ereigniserkennungsmittel, mindestens zweier als Veränderungen bei der Größenordnung definierten Ereignisse eines passiven elektrischen Stroms, welcher durch mindestens die genannte Verteilerleitung des elektrischen Netzwerks und/oder durch mindestens einen mit der genannten mindestens einer Verteilerleitung angeschlossenen Versorgungspunkt, für deren Versorgung mit Elektrizität, fließt, und der Zeit zwischen den genannten mindestens zwei erkannten Ereignissen, und
    das Vergleichen, durch die Konnektivitätsprüfmittel, der Zeit zwischen den an dem genannten Lastanschlusspunkt erkannten Ereignissen mit der Zeit zwischen den in der genannten mindestens einen Verteilerleitung des elektrischen Netzwerks und/oder an dem genannten mindestens einen Versorgungspunkt erkannten Ereignissen, um zu bestimmen, basierend mindestens auf der Ähnlichkeit zwischen den verglichenen Zeiten, an welcher Verteilerleitung oder welchen Verteilerleitungen der Lastanschlusspunkt angeschlossen ist.

10. Verfahren nach Anspruch 9, zusätzlich umfassend:

    das Erkennen, durch die ersten Ereigniserkennungsmittel, einer Vielzahl von Ereignissen an dem genannten Lastanschlusspunkt eines elektrischen Netzwerks und des von der genannten Vielzahl von erkannten Ereignissen gefolgten Zeitrasters;
    das Erkennen, durch die zweiten Ereigniserkennungsmittel, einer Vielzahl von den genannten Ereignissen in der genannten mindestens einen Verteilerleitung des elektrischen Netzwerks, und/oder an mindestens einem daran angeschlossenen Versorgungspunkt, und des von der genannten Vielzahl von erkannten Ereignissen gefolgten Zeitrasters, und
    das Verarbeiten, durch die Konnektivitätsprüfmittel, der erkannten Daten, indem die genannten Zeitraster verglichen werden, um zu bestimmen, basierend mindestens auf der Ähnlichkeit zwischen den genannten verglichenen Zeitrastern, an welcher Verteilerleitung oder welchen Verteilerleitungen der Lastanschlusspunkt angeschlossen ist.

11. Verfahren nach Anspruch 9 oder 10, zusätzlich umfassend das Durchführen einer Gegenkontrolle von Zeitrastern und einer Gegenkontrolle von erkannten Ereignissen, um zu bestimmen, an welcher Verteilerleitung oder welchen Verteilerleitungen der Lastanschlusspunkt angeschlossen ist.

12. Verfahren nach Anspruch 9, umfassend das Speichern der erkannten Ereignisse zusammen mit entsprechenden Zeitstempeln, welche die Zeitpunkte in welchen die Ereignisse stattgefunden haben bezeichnen, in einem Speicher.

13. Verfahren nach einem der vorhergehenden Ansprüche 9 bis 12, zusätzlich umfassend das Anwenden einer mathematischen oder statistischen Funktion zum Identifizieren ob der Lastanschlusspunkt zu den nicht-technischen Verlusten in der Verteilerleitung oder den Verteilerleitungen beiträgt, wobei die genannte mathematische oder statistische Funktion physische, von den genannten zweiten Ereigniserkennungsmittel gemessene Größen den physischen, von den ersten Ereigniserkennungsmittel gemessenen Größen zuordnet, wobei die genannten physischen Größen mindestens die momentane Intensität, RMS oder Energie umfassen.

14. Verfahren nach Anspruch 13, wobei die genannte mathematische oder statistische Funktion die Verwendung von mindestens zwei unabhängigen Variablen umfasst, inklusive einer Veränderung bei der Amplitude der erkannten Ereignisse und des Zeitunterschiedes derselben.

15. Verfahren nach Anspruch 9 oder 10, umfassend die Ausführung von kodierten Befehlen eines Computerprograms unter Verwendung mindestens eines Prozessors, um Daten bezüglich der genannten Zeiten zwischen Ereignissen zu verarbeiten und das genannte Vergleichen derselben durchzuführen, und um zu bestimmen, an welcher Verteilerleitung oder welchen Verteilerleitungen der Lastanschlusspunkt angeschlossen ist.

16. Verfahren nach Anspruch 15, wobei die genannten kodierten Befehle das genannte Vergleichen zusätzlich unter Berücksichtigung der Ähnlichkeit der verglichenen Ereignisse durchführen, um zu bestimmen, an welcher Verteilerleitung oder welchen Verteilerleitungen der Lastanschlusspunkt angeschlossen ist.

**Revendications**

1. Un système pour identifier les conditions de connectivité dans les réseaux électriques comportant:

des premiers moyens (1) de détection d'évènements qui sont couplés à un point de connexion de charge (5) du réseau électrique, qui peuvent détecter un changement de l'intensité du courant électrique circulant à ce point de connexion de charge (5).
des deuxièmes moyens (2) de détection d'évènements qui peuvent être couplés à une ligne (4) du réseau de distribution d'électricité, qui peuvent détecter un changement de l'intensité du courant électrique circulant dans cette ligne de distribution (4); et
des moyens pour vérifier la connectivité en comparant les évènements détectés par les premiers moyens (1) de détection d'évènements et les évènements détectés par les deuxièmes (2) moyens de détection d'évènements pour déterminer à quelle ligne correspond l'évènement produit au point (5) de connexion de charge,

dans lequel ces deuxièmes moyens (2) de détection d'évènements contiennent un enregistrement chronologique d'un ou de plusieurs premiers moyens (1) de détection d'évènements, autant qu'il y a un des premiers moyens (1) de détection d'évènements de connexion de charge (5) connectés en aval de cette ligne de distribution (4),
ce système étant **caractérisé en ce que**:

les premiers moyens (1) de détection d'évènements comportent au moins un capteur de courant et au moins une horloge , et ils sont configurés et agencés pour détecter au moins deux évènements définis comme des changements d'intensité d'un courant électrique passif circulant à travers ce point (5) de connexion de charge et l'écart entre ces au moins deux évènements détectés.
les deuxièmes moyens (2) de détection d'évènements comportent au moins un capteur de courant et au moins une horloge , et ils sont configurés et agencés pour détecter au moins deux évènements définis comme des changements d'intensité d'un courant électrique passif circulant à travers au moins cette ligne de distribution (4) et/ou à travers au moins un point d'alimentation connecté à cette au moins une ligne (4) de distribution pour l'alimenter en électricité et l'écart entre ces au moins deux évènements détectés, et
les moyens de vérification de la connectivité ont accès à des données concernant à ces écarts entre évènements, fournies par les premier et deuxième moyens (1,2) de détection d'évènements et ils sont configurés, agencés et adaptés pour traiter ces données en comparant l'écart entre les évènements détectés par les premiers moyens (1) de détection et l'écart entre les évènements détectés par les deuxièmes moyens (2) de détection, pour déterminer, basé au moins sur la similitude de ces écarts comparés, à quelle ligne ou lignes de distribution le point (5) de connexion de charge est connecté.

2. Le système conformément à la revendication 1, dans lequel:

les premiers moyens (1) de détection d'évènements sont configurés et agencés pour détecter une pluralité de ces évènements à ce point (5) de connexion de charge d'un réseau électrique et le modèle d'écarts suivi par cette pluralité d'évènements détectés,

les deuxièmes moyens (2) de détection d'évènements sont configurés et agencés pour détecter une pluralité de ces évènements dans cette ligne de distribution (4), et/ou au moins à un point d'alimentation qui y est connecté et le modèle d'écarts suivi par cette pluralité d'évènements détectés, et

les moyens de vérification de la connectivité ont accès à des données concernant ces modèles d'écarts, fournies par les premier et deuxième moyens (1,2) de détection d'évènements et ils sont configurés, agencés et adaptés pour traiter ces données en comparant ces modèles d'écarts pour déterminer, basé au moins sur la similitude de ces modèles d'écarts comparés, à quelle ligne ou lignes de distribution (4) le point de connexion de charge (5) est électriquement connecté.

3. Le système conformément à la revendication 2, dans lequel:

les premiers moyens (1) de détection d'évènements sont configurés et agencés pour détecter une pluralité de ces évènements à chacun d'une pluralité de points (5) de connexion de charge d'un réseau électrique et les modèles d'écarts suivis par cette pluralité d'évènements détectés,

les deuxièmes moyens (2) de détection d'évènements sont configurés et agencés pour détecter une pluralité de ces évènements dans chacune de deux ou plusieurs lignes de distribution (4), du réseau électrique et/ou deux ou plusieurs points d'alimentation qui y sont connectés et les modèles d'écarts suivis par cette pluralité d'évènements détectés, et

les moyens de vérification de la connectivité ont accès à des données concernant ces modèles d'écarts, fournies par les premier et deuxième moyens (1,2) de détection d'évènements et ils sont configurés, agencés et adaptés pour traiter ces données en comparant ces modèles d'écarts pour déterminer, basé au moins sur la similitude de ces modèles d'écarts comparés, à quelle ligne ou lignes de distribution (4) chacun de ces points (5) de connexion de charge est électriquement connecté.

4. Le système conformément une quelconque des revendications précédentes dans lequel les moyens de détection vérifiant la connectivité sont de plus configurés pour identifier quel point ou quels points (5) de connexion de charge sont susceptibles de contribuer à des pertes non techniques dans la ligne ou les lignes (4) de distribution et de générer un signal d'alarme si cette contribution de pertes non techniques intervient.

5. Le système conformément à la revendication 3, dans lequel le système est appliqué à un réseau de distribution d'électricité comportant des lignes couplées et/ou en anneau où au moins un de ces points (5) de connexion de charge est connecté à deux ou plusieurs de ces lignes couplées et/ou en anneau et où les deuxièmes moyens (2) de détection d'évènements sont configurés, agencés pour détecter cette pluralité d'évènements et les modèles d'écarts entre évènements dans ces deux ou plusieurs lignes couplées et/ou encerclées.

6. Le système conformément à la revendication 3, dans lequel les deuxièmes moyens de détection d'évènements sont configurés et agencés pour détecter cette pluralité d'évènements à au moins un point d'alimentation connecté à l'extrémité de la tête de la ligne (4) de distribution et à au moins un autre point d'alimentation connecté à un point intermédiaire de la même ligne de distribution (4).

7. Le système conformément à la revendication 1, dans lequel au moins une horloge des premiers moyens (1) de détection d'évènements est indépendante d'au moins une horloge des deuxièmes moyens (2) de détection d'évènements pour effectuer leurs détections respectives d'écarts entre des évènements indépendamment.

8. Le système conformément à la revendication 1, dans lequel les premiers moyens (1) de détection d'évènements et les deuxièmes moyens (2) de détection d'évènements comportent des moyens de stockage pour mettre en mémoire les éléments détectés avec leur horodatage correspondant indiquant les moments auxquels les évènements ont eu lieu.

9. Une méthode pour identifier les conditions de connectivité dans les réseaux électriques comportant:

la détection, par des premiers moyens de détection d'évènements qui sont couplés à un point de connexion de charge du réseau électrique, d'un évènement comportant un changement dans l'intensité du courant électrique circulant à ce point du réseau électrique;

la détection, par des deuxièmes moyens de détection d'évènements qui sont couplés à une ligne du réseau électrique, d'un évènement comportant un changement dans l'intensité du courant électrique circulant sur cette ligne du réseau de distribution électrique; et

la comparaison, par des moyens de vérification de la connectivité, des changements d'intensité du courant électrique détectés au point de connexion du réseau avec les changements d'intensité du courant électrique détectés dans la ligne électrique pour déterminer à quelle ligne l'évènement qui a lieu au point de connexion correspond,

dans laquelle ces deuxièmes moyens (2) de détection d'évènements contiennent un enregistrement chronologique d'un ou plusieurs premiers moyens (1) de détection d'évènements, autant que de premiers moyens (1) de détection d'évènements de la connexion de charge (5) connectés en aval de cette ligne de distribution (4), **caractérisé en ce que** cette méthode comporte en plus :

la détection par les premiers moyens de détection d'évènements, d'au moins deux évènements définis comme des changements de l'intensité d'un courant électrique passif circulant par ce point de connexion de charge d'un réseau électrique et l'écart entre ces au moins deux évènements détectés,

la détection, par les deuxièmes moyens de détection d'évènements, d'au moins deux évènements définis comme des changements de l'intensité d'un courant électrique passif circulant par au moins cette ligne de distribution du réseau électrique et/ou par au moins un point d'alimentation connecté à cette au moins une ligne de distribution, pour l'alimenter en électricité et l'écart ente ces au moins deux évènements détectés, et

la comparaison, par les moyens de vérification de la connectivité, de l'écart entre les évènements détectés à ce point de connexion et l'écart entre les évènements détectés dans cette au moins une ligne de distribution du réseau électrique et/ou à cet au moins un point d'alimentation, basé au moins sur la similitude de ces écarts comparés, à quelle ligne ou lignes de distribution le point de connexion est connecté.

**10.** La méthode conformément à la revendication 9 comporte en plus:

la détection par les premiers moyens de détection d'évènements, d'une pluralité d'évènements à ce point de connexion de charge d'un réseau électrique et le modèle d'écarts suivi par cette pluralité d'évènements détectés:

la détection par les deuxièmes moyens de détection d'évènements, d'une pluralité de ces évènements dans cette au moins une ligne de distribution du réseau électrique et/ou au moins un point d'alimentation qui y est connecté et le modèle d'écarts suivi par cette pluralité d'évènements détectés; et

le traitement, par les moyens de vérification de connectivité, de ces données détectées en comparant ces modèles d'écarts pour déterminer, basé sur la similitude de ces modèles d'écarts comparés, à quelle ligne ou lignes le point de connexion de charge est connecté.

**11.** La méthode conformément à la revendication 9 ou 10, comporte en plus faire un recoupement du modèle d'écarts et un recoupement de l'évènement détecté pour déterminer à quelle ligne ou lignes de distribution le point de connexion de charge est connecté.

**12.** La méthode conformément à la revendication 9, comportant la mise en mémoire des évènements détectés avec l'horodatage correspondant indicatif des moments auxquels les évènements sont intervenus.

**13.** La méthode conformément à une quelconque des revendications précédentes 9 à 12, comportant en plus l'application d'une fonction mathématique ou statistique pour identifier si le point de connexion de charge contribue aux pertes non techniques dans de la ligne ou des lignes de distribution, dans laquelle cette fonction mathématique ou statistique concerne les grandeurs physiques mesurées par ces deuxièmes moyens de détection d'évènements, ces grandeurs physiques étant mesurées par les premiers moyens de détection, ces grandeurs physiques comportant au moins l'intensité instantanée, RMS ou l'énergie.

**14.** La méthode conformément à la revendication 13, dans laquelle cette fonction mathématique ou statistique comporte l'utilisation d'au moins deux variables indépendantes comprenant un changement d'intensité des évènements détectés et leur différence d'écart.

**15.** La méthode conformément à la revendication 9 ou 10, comportant les instructions de codes pour l'exécution d'un programme informatique en utilisant au moins un processeur pour traiter les données concernant ces écarts entre évènements et en faire la comparaison et pour déterminer à quelle ligne ou lignes de distribution le point de connexion de charge est connecté.

**16.** La méthode conformément à la revendication 15, dans laquelle ces instructions de codes effectuent ces comparaisons en tenant compte de plus de la similitude des évènements comparés pour déterminer à quelle ligne ou lignes le point de connexion de charge est connecté.

FIG.1

FIG.2

Event pattern with absolute timestamp at source

## FIG. 3

Event pattern with absolute timestamp at end point

## FIG. 4

FIG. 5

Time invariability between source and meter events

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013186404 A